## Europäisches Patentamt

## European Patent Office

## Office européen des brevets

(19)

(11) Veröffentlichungsnummer: **0 120 395**
**B1**

(12) # EUROPÄISCHE PATENTSCHRIFT

(45) Veröffentlichungstag der Patentschrift:
04.02.87

(21) Anmeldenummer: **84102704.8**

(22) Anmeldetag: **13.03.84**

(51) Int. Cl.⁴: **C 30 B 11/00,** C 30 B 11/14,
C 01 B 33/02

(54) Verfahren zur Herstellung von grobkristallinem Silicium.

(30) Priorität: **24.03.83 DE 3310627**

(43) Veröffentlichungstag der Anmeldung:
**03.10.84 Patentblatt 84/40**

(45) Bekanntmachung des Hinweises auf die Patenterteilung:
**04.02.87 Patentblatt 87/6**

(84) Benannte Vertragsstaaten:
**BE DE FR GB IT NL**

(56) Entgegenhaltungen:
**DE-A-3 150 539**
**FR-A-2 500 854**
**US-A-3 986 837**

(73) Patentinhaber: **BAYER AG, Konzernverwaltung RP
Patentabteilung, D-5090 Leverkusen 1 Bayerwerk
(DE)**

(72) Erfinder: **Schwirtlich, Ingo, Dr., St. Antonstrasse
231, D-4150 Krefeld (DE)**
Erfinder: **Woditsch, Peter, Dr., Deswatinesstrasse
83, D-4150 Krefeld (DE)**
Erfinder: **Koch, Wolfgang, Dr.,
Hoeninghausstrasse 63, D-4150 Krefeld (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1987

## Beschreibung

Die vorliegende Erfindung betrifft ein Verfahren zur Herstellung von Siliciumblöcken mit kolumnar erstarrten grobkristallinen Bereichen durch Abkühlen einer Siliciumschmelze in einer vorgegebenen Form.

Die Verknappung und Verteuerung der fossilen Energiequellen hat zu einer verstärkten Suche nach alternativen Energiequellen geführt. Weltweit wird dabei mit hohem Aufwand nach Möglichkeiten gesucht, die Sonnenenergie für eine Energiegewinnung einzusetzen.

Neben den thermischen Energiegewinnungsverfahren ist die direkte Umwandlung der Sonnenenergie in elektrischen Strom mit Hilfe des photovoltaischen Effektes unter Einsatz geeigneter Halbleiter eine vielversprechende Alternative um den Energiebedarf der Zukunft zu decken.

Bereits heute sind Solarzellen auf Basis von Silicium die fast alleinige Grundlage der Energieversorgung von Satelliten im Weltraum. Das dabei eingesetzte Silicium aus der Halbleitertechnik ist jedoch zu teuer für die terrestrische Energieerzeugung, so daß es nicht an Versuchen gefehlt hat, kostengünstiger Silicium, Siliciumscheiben und daraus Solarzellen zu fertigen.

Ein wesentlicher Schritt in der Kette der Kostenreduktion ist der Ersatz komplizierter Einkristallzüchtungsverfahren (z.B. nach Czochralski) durch ein rasches, möglichst halbkontinuierliches Gießverfahren. Ziel muß dabei die Erhaltung eines hohen Wirkungsgrades der aus derartigen Siliciumblöcken durch Sägen gewonnenen Siliciumscheiben sein. Nach heutigem Erkenntnisstand ist ein hoher Wirkungsgrad bei der Umwandlung von Sonnenlicht in Strom dann gegeben, wenn neben der hinreichenden Reinheit in der Siliciumscheibe möglichst wenig Korngrenzen auftreten, d.h. überwiegend einkristalline Bereiche vorhanden sind. Diese sollen möglichst wenig Gitterfehler wie Versetzungen, Leerstellen, Zwischengitteratomen aufweisen.

Es hat in den letzten Jahren nicht an Versuchen gefehlt, ein entsprechendes Material zur Verfügung zu stellen. So ist aus der US-C 4 243 471 ein Verfahren bekannt, um kristallines Silicium durch gerichtetes Erstarren zu erhalten. Der Ausdehnung des Siliciums beim Übergang vom flüssigen in den festen Zustand um ca. 10% wird in diesem Fall dadurch begegnet, daß man Silicium nach dem Aufschmelzen in einem mittelfrequenzbeheizten Graphitsuszeptor durch langsames Absenken des Behälters vom Boden her erstarren läßt. Durch den Einsatz einer Gußkokille, deren Ausdehnungskoeffizient bei 3,0 - 4,3 . $10^{-6}$ °C$^{-1}$ im Temperaturbereich von 20-650°C liegt, soll sichergestellt werden, daß gerichtet erstarrtes Silicium in diesem Temperaturbereich keinen thermischen Spannungen ausgesetzt wird, die durch Anhaften des Siliciums an der Gefäßwand oder durch den im Vergleich zum Silicium größeren Ausdehnungskoeffizienten entstehen.

Dieses Verfahren besitzt aber den erheblichen Nachteil, daß sich nur schwer eine gleichmäßige Erstarrungsfront ausbildet. Durch weiteres Heizen mit der Mittelfrequenzspule bilden sich erhebliche Turbulenzen, die sich ebenfalls nachteilig auf die Kristallisationsfront auswirken und Gitterstörungen verursachen können.

Der Beginn der Kristallisation, welcher bei allen Verfahren besonders kritisch ist, setzt hier am Boden des Behälters ein und führt aufgrund des keimbildenden Einflußes der Oberflächenrauhigkeit zu einer Vielzahl von Kristalliten, die miteinander konkurrierend wachsen, so daß sich nur relativ kleine einkristalline Bereiche ausbilden können.

Gemäß der DE-A 3 138 227 wird Silicium in einem Quarzgefäß aufgeschmolzen und auf einer Temperatur wenig oberhalb des Schmelzpunktes gehalten. Ein von vornherein am Boden des Schmelzgefäßes angebrachter einkristalliner Siliciumkeim, der durch eine Gaskühlung auf einer Temperatur gehalten wird, die ein Aufschmelzen verhindert, dient hier als Impfkristall. Dadurch wird bewirkt, daß im Verlauf von mehreren Stunden nun die Kristallisation unter Kühlung des Siliciums vom Boden her erfolgt. Nach diesem Verfahren können überwiegend einkristalline Bereiche erhalten werden, außerdem erfolgt eine zusätzliche Reinigung der Siliciumschmelze aufgrund der unterschiedlichen Löslichkeiten der meisten Verunreinigungen in flüssigem und festem Silicium. Der Nachteil dieses sogenannten Wärmetauscherverfahrens besteht in der langsamen Erstarrung des Schmelzvolumens, da die gesamte, beim Silicium sehr hohe Schmelzwärme über die gasgekühlte Si-Einkristallplatte und die geringe Wärmekapazität des Kühlgases abgeführt werden muß. Dies führt bereits bei relativ kleinen Blöcken zu langen Kristallisationszeiten von vielen Stunden. Si-Blöcke von 20 x 20 x 10 cm$^3$ erfordern Kristallisationszeiten von mehreren Tagen. Es ist ein weiterer Nachteil dieses Verfahrens, daß es nicht semikontinuierlich durchgeführt werden kann, indem man Schmelztiegel und Erstarrungsgefäß voneinander separiert und so in einem Tiegel rasch aufschmilzt und dann in mehrere Erstarrungskokillen abgießt.

Die mit der langsamen Kristallisation verbundene Reinigungswirkung aufgrund der Segregationskoefizienten für Verunreinigungen in Silicium ist allen Verfahren mit einer gerichteten und kontrolliert einstellbaren Kristallisationsgeschwindigkeit gemeinsam.

Größere Durchsätze in einem halbkontinuierlichen Verfahren werden gemäß der DE-B 2 745 247 erhalten. Danach werden Siliciumformkörper mit Kolumnarstruktur durch Eingießen einer Siliciumschmelze in eine Form und Erstarrenlassen der Schmelze erhalten, wobei man die Kontaktfläche der Gießform mit der einen der beiden größten einander gegenüberliegenden Begrenzungsflächen der Schmelze auf einer Temperatur von maximal 1200° C hält und die gegenüberliegende Begrenzungsfläche der Schmelze einer 200 bis 1000° C darüberliegenden Temperatur, aber unterhalb des Festpunktes von Silicium, aussetzt. Anschließend erfolgt das Abkühlen der Gußkokille, wobei die Schmelzwärme des Siliciums durch intesive Kühlung des Bodens der Form abgeführt wird. Es resultiert ein polykristallines Silicium bei dem eine gerichtete Erstarrung erzwungen wird. Die Keimbildung erfolgt auch hier am Boden der Gußkokille und damit an einer Fremdoberfläche mit den damit verbundenen Nachteilen.

Alle hier beschriebenen gerichteten Erstarrungsverfahren weisen den Nachteil auf, daß durch heterogene Keimbildung an den Kokillenwänden, insbesondere aber am Kokillenboden, immer eine Vielzahl von Kristalliten entstehen, die zwar zu kolumnar erstarrtem Silicium führen, wobei aber durch die konkurrierenden Wachstumsprozesse bei Kokillen von 10 x 10 cm$^2$ nur Korndurchmesser von einigen Millimetern resultieren.

Das Wärmetauschverfahren führt zwar zu gröberkristallinem Material mit überwiegend einkristallinen Bereichen, ist aber langwierig, aufwendig und damit unwirtschaftlich.

Aus der FR-A 25 00 854 ist weiterhin ein Verfahren zur Herstellung einzelner Scheiben aus einer Siliciumschmelze bekannt. Diese Scheiben kristallisieren von einem Impfkristall von der Oberfläche der Schmelze in einem die Scheibengröße vorgegebenen Rahmen und erreichen nach einer vorgegebenen Zeit eine Dicke von ca. 0,4 mm. Die Bildung von geeigneten Siliciumblöcken ist weder angestrebt noch möglich.

Die US-A 3 986 837 betrifft die Kristallisation von Verbindungshalbleitern, insbesondere Gallinmarsenid. Dieses Material zeigt bei der· Erstarrung keine Volumenausdehnung, so daß keine gerichtete Erstarrung erforderlich ist. Die Hauptprobleme, die mit der Kristallisation von Silicium verbunden sind, treten daher dort nicht auf.

Aufgabe der vorliegenden Erfindung ist es somit, ein Verfahren zur Verfügung zu stellen, welches die Nachteile der oben beschriebenen Verfahren nicht aufweist.

Überraschenderweise wurde nun gefunden, daß erhebliche gröbere Silicium-Kristalle mit Vorzugsrichtung auch bei hohen Kristallisationsgeschwindigkeiten erhalten werden können, wenn eine Keimbildung an der Schmelzoberfläche einsetzt und die Kristallisation von der Oberfläche der Schmelze zum Boden der Kokille erfolgt.

Gegenstand der vorliegenden Erfindung ist somit ein Verfahren zur Herstellung von Siliciumblöcken mit kolumnar erstarrten grobkristallinen Bereichen durch Abkühlen einer Siliciumschmelze, welches dadurch gekennzeichnet ist, daß man die Erstarrung an der Oberfläche der Schmelze beginnen läßt und die Kristallisation durch kontrollierte Wärmeabfuhr von der Oberfläche durch ein oder mehrere aufgelegte oder eingetauchte einkristalline Impfstücke aus Silicium eingeleitet wird, wobei die Wärmeabfuhr durch Größe und Temperatur der Impfkristalle gesteuert wird.

Die nach dem erfindungsgemäßen Verfahren erstarrten Formkörper sind kolumnar erstarrt, zeigen überwiegend große einkristalline Kristallbereiche und weisen überwiegend eine kristallographische Vorzugsorientierung auf.

Eindrucksvoll ist die Ausbildung größerer Kristallstrukturen bei der Erstarrung von der Oberfläche her, wenn eine Kristallisation gleichzeitig von der Schmelzoberfläche und vom Boden her erfolgt. Die Kristallisation in Richtung der Schwerkraft ist dabei sowohl hinsichtlich der Keimbildung, als auch des weiteren Wachstums deutlich begünstigt.

Die Zahl der an der Oberfläche eingesetzten oder erzeugten Keime kann gesteuert und variiert werden.

Zur Steuerung des Kristallwachstums ist es vorteilhaft, durch ein aufeinander abgestimmtes Kühlen der Schmelzoberfläche und Heizen des Kristallisationsgefäßes zu einer Feinregulierung der Temperaturverhältnisse zu kommen.

Die Keimbildung an der Oberfläche und der Kristallisationsprozeß als solcher werden dabei durch die folgenden Parameter gesteuert: Temperatur der Siliciumschmelze vor Beginn der Kristallisation, Größe des gekühlten Oberflächenbereiches, Wärmeabfuhr nach Einsetzen der Kristallisation, Größe und Temperatur von Impfkristallen.

Das erfindungsgemäße Verfahren ist grundsätzlich unabhängig von den herrschenden Druckverhältnissen. Es läßt sich daher sowohl im Vakuum als auch unter Atmosphärendruck vorteilhaft einsetzen. Der Druck kann dabei als Steuergröße der Wärmeabfuhr von der kristallisierenden Oberfläche eingesetzt werden. Beispielsweise kann nach einer Keimbildung im Vakuum bei niedrigen Drücken von wenigen Millibar die Wärmeabfuhr unter sonst gleichen Bedingungen dadurch vergrößert werden, daß mit Inertgas ein steigender Druck aufgebaut wird.

Eine Heizung des Kristallisationsgefäßes ist nach allen bekannten und bis heute technisch zugänglichen Verfahren möglich.

Das eingesetzte Kokillenmaterial ist für die Kristallisation bei dem erfindungsgemäßen Verfahren unkritisch, solange die Anforderungen hinsichtlich der Beständigkeit gegenüber flüssigem Silicium gegeben sind. Aus Gründen der Reinheit der Siliciumkristalle sind Kokillen aus Graphit, Siliciumnitrit oder Siliciumcarbid ohne besondere Probleme einsetzbar. Auch Kokillen, die mit Siliciumnitrit oder Siliciumcarbid beschichtet sind können insbesondere für eine großtechnische Ausgestaltung angewandt werden, um eine kostengünstige Produktion zu gewährleisten. Gegenüber dem Einsatz von Quarzgefäßen sind siliciumnitridhaltige

Oberflächen begünstigt. Eine Si$_3$N$_4$-Beschichtung von Quarztiegeln kann deren Einsatz weiter verbessern, da in diesen Fällen kein Anbacken des kristallinen Siliciums an der Kokillenwand beobachtet wird und damit keine Verhaftung zwischen der Kokille und dem erstarrten Silicium erfolgt.

Die bereits vorhandene Möglichkeit, bei einer langsamen Kristallisation eine zusätzliche Reinigung aufgrund der unterschiedlichen Löslichkeiten von Verunreinigungen in flüssigem und festem Silicium zu erzielen, sind auch bei dem erfindungsgemäßen Kristallisationsverfahren gegeben. Damit läßt es sich für Kristallisationsverfahren von vorgereinigtem metallugischem Silicium ebenso einsetzten wie das Wärmetauscherverfahren.

Eine besonders gute Reinigung läßt sich erzielen, wenn man nicht die gesamte Schmelze erstarren läßt, sondern nur einen Anteil von 30 oder 50 aus wirtschaftlichen Gründen bis zu 80 % des flüssigen Siliciums auskristallisieren läßt. Das erstarrte Silicium wird dabei von der Restschmelze getrennt, die anschließend erneut verwendet werden oder einem Reinigungsverfahren unterzogen werden kann. Unter gewissen Umständen kann es dabei sogar sinnvoll sein, einen zusätzlichen Bearbeitungsschritt des Zurechtsägens des erstarrten Siliciumblockes in Kauf zu nehmen, wenn dafür von weniger aufwendig gereinigtem Silicium ausgegangen werden kann.

Die Entfernung des bereits zu 50 bis 90 % erstarrten Siliciumblockes von der Restschmelze ist nach verschiedenen Verfahren möglich und für das erfindungsgemäße Verfahren ohne Bedeutung. Vom Anfrieren eines Stabes z.B. aus Silicium bis zum Abgießen der Restschmelze bieten sich viele Möglichkeiten an.

Eine andere ebenfalls im Rahmen der Erfindung liegende Ausführungsvariante geht davon aus, daß die gesamte Siliciumschmelze zur Kristallisation gebraucht wird. Dabei muß, um die Vorteile des erfindungsgemäßen Verfahrens voll zu nutzen, nach Möglichkeit für einen Druckausgleich gesorgt werden. Eine Beeinträchtigung der Kristallisation durch die Volumenausdehnung des Siliciums kann vermieden werden, wenn ein Einschluß der Restschmelze durch die Kristallisationsfront und das bereits erstarrte Silicium bzw. die Kokillenwandungen vermieden wird. Möglichkeiten dafür bieten z.B. ein Überlauf, eine beheizte Zone innerhalb der Kokille oder eine vorbereitete Sollbruchstelle in der Kokillenwand.

Da dieses Verfahren zur Erstarrung einer Siliciumschmelze so geführt wird, daß möglichst geringe Störungen an der Erstarrungsfront auftreten und durch die Versuchsführung der nachteilige Einfluß der Schwerkraft sogar deutlich vermindert werden kann, werden Kristallbereiche mit geringeren Störungen erzielt als bei der Erstarrung entgegen der Schwerkraft.

Auf diese Weise gewonnene Siliciumblöcke sind nach bekannten Verfahren zu sägen und führen dann zu Siliciumscheiben, die man vorteilhaft als Ausgangsprodukt für die Herstellung von Solarzellen verwenden kann.

Im folgenden wird die Erfindung beispielsweise erläutert, was aber keine Einschränkung der Erfindung bedeutet.

## Beispiel 1

Das folgende Beispiel dient dazu, den Unterschied in der Größe der sich bildenden Kristalle zu verdeutlichen, die einmal von der Kokillenwand ausgehend gewachsen sind und zum anderen von der freien Oberfläche aus.

Dazu wurde eine Si$_3$N$_4$ beschichtete Kokille mit einer Bodenfläche von 100 x 100 mm$^2$ durch eine Widerstandsheizung auf ca. 1350° C (1,4 kW) erhitzt. Durch eine entsprechend gewählte Isolierung wurde dafür gesorgt, daß die Wärmeabstrahlung aus dem oberen Kokillenbereich größer war als aus dem unteren. Der Wärmeverlust des oberen Kokillenteiles wurde durch eine höhere Tempratur der Widerstandsheizung in diesem Bereich kompensiert.

Pulverförmiges Silicium wurde in einem mittelfrequenzbeheizten Graphittiegel aufgeschmolzen und bei 1500° C in die Kokille abgegossen.

Direkt nach diesem Abguß wurde die Leistung der Kokillenheizung um 170 W/h kontinuierlich reduziert. Das vollständige Erstarren des Si-Blockes konnte aus dem beschleunigten Temperaturabfall nach ca. 170 min gefolgert werden.

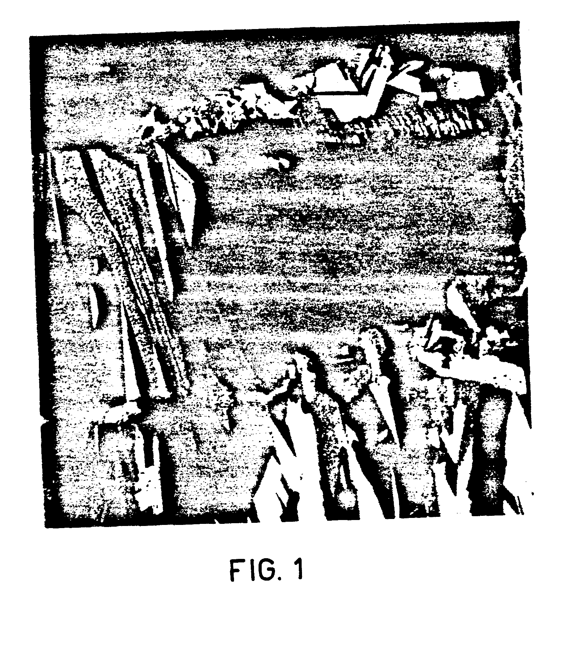

Der auf Raumtemperatur abgekühlte Block zeigte eine deutlich gröbere Kristallstruktur in dem von der Schmelzoberfläche her erstarrten Bereich, der ca. 40 % des Blockvolumens umfaßte, wenn man mit dem vom Kokillenboden her erstarrten Bereich vergleicht (Fig. 1).

Der durch die Volumenausdehnung bei der Erstarrung bedingte Druckanstieg zwischen den Erstarrungsfronten wurde in diesem Fall durch Hochdrücken der Restschmelze entlang der Kokillenwand abgebaut.

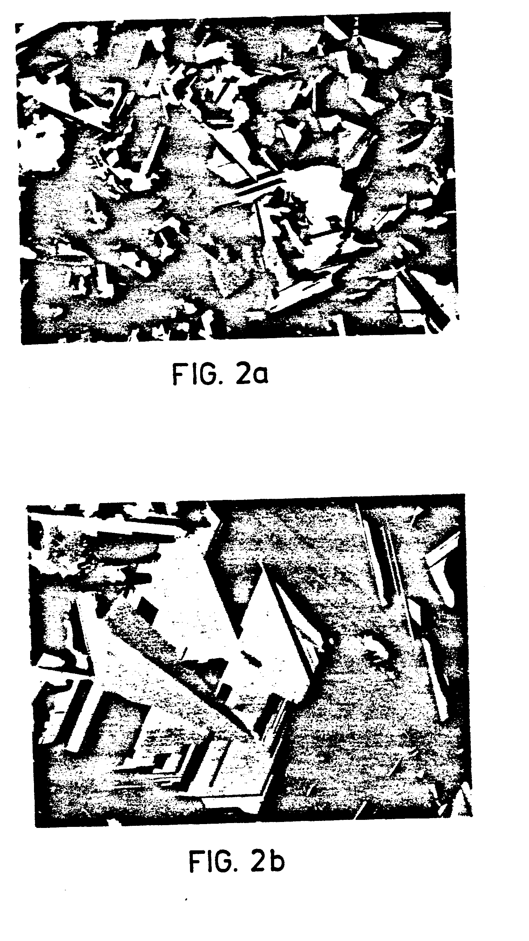

In Fig. 2 ist die unterschiedliche Korngröße des von oben erstarrten Bereiches verglichen mit dem von unten erstarrten anhand der entsprechend herausgeschnittenen Scheiben deutlich zu sehen.

## Beispiel 2

Im vorliegenden Beispiel wurde auf die Ausbildung übergroßer Körner zugunsten einer schnellen Abkühlzeit verzichtet.

Eine Kokille, die der im ersten Beispiel vergleichbar ist, wurde mit Hilfe einer Widerstandsheizung gleichmäßig auf 1430° C erwärmt. Die Isolationsverhältnisse wurden so gewählt, daß hauptsächlich der obere Bereich der Kokille Wärme abstrahlen konnte. Nachdem pulverförmiges Silicium induktiv im Graphittiegel aufgeschmolzen und auf 1500°C erwärmt worden war, wurde es bei ca. $10^{-4}$ mbar in die erhitzte Kokille abgegossen. Nach dem Abguß wurde durch Einleiten von Ar der Druck innerhalb von 10 min auf 800 mbar erhöht. Die bis dahin konstante Widerstandsheizung der Kokille wurde darauf ausgeschaltet und das System sich selbst überlassen. Nach 3 h bereits konnte der Si-Block der Apparatur entnommen werden. Er zeigte eine grobkristalline Struktur, die sich von der Schmelzoberfläche ausgehend bis zum Boden der Kokille ausgebreitet hatte. Die Kristallkörner besaßen einen Durchmesser von ca. 1,0 cm bei einer Länge von einigen Zentimetern.

Der Abbau des durch die Volumenausdehnung bedingten Druckes geschah durch Sprengen des bewußt schwach ausgebildeten Kokillenbodens, der die Funktion einer Sollbruchstelle innehatte. Bemerkenswert dabei war, daß kein flüssiges Silicium austrat.

**Beispiel 3**

Im folgenden Beispiel wurde die Kristallisation an der Oberfläche durch einen in die Schmelze eingetauchten Impfling von 1 cm²-Fläche eingeleitet, das durch langsames Erhöhen des Gasdruckes auf 800 mbar unterstützt wurde. Bei sonst zum ersten Beispiel vergleichbaren experimentellen Bedingungen wurde ein vom Impfling ausgehendes Kristallwachstum über ca. 50 mm beobachtet. Auch in diesem Experiment erfolte der Druckabbau durch die Zerstörung der Kokille an einer vorgesehenen Stelle ohne das schmelzflüssiges Silicium austrat.

Kurze Beschreibung der Darstellungen:

Fig. 1 zeigt die Grenzfläche der von der Oberfläche aus nach unten erstarrten und der von unten nach oben erstarrten Si-Schmelze.

Fig. 2 ist die Abbildung von Scheiben, die aus dem unteren (a) und oberen (b) Teil des Si-Blockes von Fig. 1 herausgeschnitten wurden.

**Patentansprüche**

1. Verfahren zur Herstellung von Siliciumblöcken mit kolumnar erstarrten grobkristallinen Bereichen durch Abkühlen einer Siliciumschmelze, in einer vorgegebenen Form dadurch gekennzeichnet, daß man die Erstarrung an der Oberfläche der Schmelze beginnen läßt und die Kristallisation durch kontrollierte Wärmeabfuhr von der Oberfläche durch ein oder mehrere aufgelegte oder eingetauchte einkristalline Impfstücke aus Silicium eingeleitet wird, wobei die Wärmeabfuhr durch Größe und Temperatur der Impfkristalle gesteuert wird.

2. Verfahren nach Anspruch 1, dadurch gekennzeichnet, daß mehr als 30 %, aber weniger als 80 % der Schmelze einer gerichteten Erstarrung und Kristallisation von oben nach unten unterworfen wird.

**Claims**

1. Process for the production of silicon blocks containing coarse-crystalline regions which have solidified in a columnar manner by cooling a silicon melt, in a specified mould, characterised in that the solidification is allowed to begin at the surface of the melt and crystallisation is induced by controlled dissipation of heat from the surface by one or more superimposed or immersed monocrystalline seeding pieces of silicon, the dissipation of heat being controlled by the size and temperature of the seed crystals.

2. Process according to Claim 1, characterised in that more than 30%, but less than 80% of the melt is subjected to orientated solidification and crystallisation from the top downwards.

**Revendications**

1. Procédé de production, sous une forme prédéterminée, de blocs de silicium présentant des domaines à gros cristaux solidifiés en colonne, par refroidissement d'une masse de silicium en fusion, caractérisé en ce qu'on fait débuter la solidification à la surface de la masse en fusion et on déclenche la cristallisation par dissipation contrôlée de la chaleur de la surface par un ou plusieurs germes de silicium monocristallins déposés ou immergés, la dissipation de chaleur étant régie par la grandeur et la température des germes cristallins.

2. Procédé suivant la revendication 1, caractérisé en ce qu'on soumet plus de 30 % mais moins de 80 % de la masse en fusion à une solidification et une cristallisation dirigées, de haut en bas.

FIG. 1

FIG. 2a

FIG. 2b